# FASCICULE DE BREVET EUROPEEN

(11) **EP 1 087 424 B1**
(45) Date de publication et mention de la délivrance du brevet: **11.01.2006**
(21) Numéro de dépôt: 00402612.6
(22) Date de dépôt: 21.09.2000
(51) Int. Cl.: H01L 21/00, H01L 21/22, H01L 29/732, H01L 21/331

(54) **Procédé de fabrication d'un transistor bipolaire vertical auto-aligné**
Verfahren zur Herstellung eines selbstjustierten vertikalen Bipolartransistors
Method for fabricating a self-aligned vertical bipolar transistor

(30) Priorité: 23.09.1999 FR 9911895
(43) Date de publication de la demande: 28.03.2001
(73) Titulaire: STMicroelectronics S.A., 92120 Montrouge (FR)
(72) Inventeur: Chantre, Alain, 38180 Seyssins (FR); Marty, Michel, 38760 Varces (FR); Baudry, Hélène, 38100 Grenoble (FR)
(74) Mandataire: Casalonga, Axel

(56) Documents cités:
- EP-A- 0 035 126

## Description

L'invention concerne des transistors bipolaires verticaux, notamment ceux destinés à s'intégrer dans les technologies haute fréquence et à très haut degré d'intégration (technologie VLSI : "Very Large Scale Integration", en langue anglaise), et en particulier la réalisation de la base extrinsèque et de la fenêtre-émetteur de ces transistors.

Dans les technologies bipolaires à émetteur polysilicium, la région d'émetteur comporte généralement un bloc-émetteur possédant une partie inférieure plus étroite située dans une fenêtre, dite "fenêtre-émetteur", ménagée au-dessus de la base intrinsèque du transistor. Le bloc-émetteur possède également une partie supérieure plus large qui déborde de la fenêtre-émetteur et qui repose sur une couche isolante (généralement formée de deux sous-couches isolantes) au-dessus de la région de base.

L'implantation de la base extrinsèque s'effectue de part et d'autre de la partie supérieure plus large de l'émetteur.

Or, la délimitation de la fenêtre-émetteur d'une part, et celle de la partie supérieure du bloc-émetteur d'autre part, s'effectuent respectivement en utilisant deux niveaux distincts de photolithographie, et par conséquent deux masques de photolithographie.

Par ailleurs, afin d'éviter un contact entre la zone de dopants diffusée sous la fenêtre-émetteur en provenance de l'émetteur, et la limite de la zone implantée de base extrinsèque, il est nécessaire, lors de la réalisation de l'émetteur, de spécifier une distance minimale entre les limites de la fenêtre-émetteur et les limites de la partie supérieure du bloc-émetteur. Cette distance tient compte de nombreux paramètres, et notamment l'extension des zones implantées lors des recuits thermiques, ainsi que des tolérances du process de fabrication.

En outre, puisque deux masques de photolithographie, c'est-à-dire deux niveaux de photolithographie, sont utilisés, il faut également tenir compte pour l'élaboration de ladite distance, de la tolérance d'alignement entre les deux masques de photolithographie.

Et, la prise en compte de cette tolérance d'alignement nécessite d'augmenter ladite distance entre les limites de la fenêtre-émetteur et les limites de la partie supérieure du bloc-émetteur, afin d'éviter un risque de contact entre la zone diffusée sous l'émetteur et la région de base extrinsèque.

Ceci conduit donc à augmenter volontairement la surface du collecteur intrinsèque située entre les deux zones implantées de base extrinsèque, ce qui a pour conséquence d'augmenter la capacité base-collecteur.

Par ailleurs, la prise en compte de cette tolérance d'alignement conduit également à augmenter volontairement la distance entre la fenêtre-émetteur et les zones de base extrinsèque, ce qui a pour conséquence d'augmenter la résistance d'accès à la base.

Tout ceci conduit à une dispersion des caractéristiques du transistor, à une inhomogénéité des caractéristiques des transistors fabriqués sur une même plaquette et conduit à une dégradation des performances haute fréquence de ces transistors, comme par exemple la valeur de la fréquence maximale d'oscillation (fréquence de coupure du gain en puissance).

Ceci est pénalisant pour tous les types de transistors bipolaires verticaux, et tout particulièrement pour ceux destinés à s'intégrer dans les technologies haute fréquence et à très haut degré d'intégration, et qui présentent à cet égard une base épitaxiée à hétérojonction silicium-germanium (SiGe).

L'invention vise à apporter une solution à ces problèmes.

Un but de l'invention est de proposer une fabrication d'un transistor bipolaire vertical dont la base extrinsèque soit auto-alignée sur la fenêtre-émetteur, ce qui n'est pas le cas dans l'art antérieur qui vient d'être évoqué.

En effet, selon cet art antérieur, la base extrinsèque est auto-alignée sur le bloc-émetteur en polysilicium mais n'est pas auto-alignée sur la fenêtre-émetteur, puisque deux masques de photolithographie ont été utilisés, ce qui conduit à l'obtention d'une tolérance d'alignement.

D'autres procédés sont décrits dans EP-A-35126.

L'invention telle que revendiquée dans la revendication 1 propose donc un procédé de fabrication d'un transistor bipolaire comprenant une phase de réalisation d'une région de base comportant une base extrinsèque et une base intrinsèque, et une phase de réalisation d'une région d'émetteur comprenant un bloc-émetteur possédant une partie inférieure plus étroite située dans une fenêtre-émetteur ménagée au-dessus de la base intrinsèque.

Selon une caractéristique générale de l'invention, la réalisation de la base extrinsèque comporte une implantation de dopants effectuée après une délimitation de la fenêtre-émetteur, de part et d'autre et à une distance prédéterminée des limites latérales de la fenêtre-émetteur, de façon auto-alignée sur cette fenêtre-émetteur, et avant la formation du bloc-émetteur.

L'auto-alignement sur la fenêtre-émetteur de la base extrinsèque implantée, est obtenu parce que la fenêtre-émetteur est délimitée en utilisant un seul masque de photolithographie et parce que cette implantation de base extrinsèque est effectuée avant la formation du bloc-émetteur. L'invention se distingue donc de l'art antérieur qui prévoyait un auto-alignement de la base extrinsèque non pas sur la fenêtre-émetteur, mais sur le bloc-émetteur polysilicium, et dans lequel, en outre, l'implantation de la base extrinsèque était effectuée après la formation du bloc-émetteur.

L'invention s'applique à tout type de transistor bipolaire vertical quel que soit le type de la base utilisé, que celle-ci soit une base classique en silicium ou bien une base à hétérojonction silicium-germanium, et quel que soit le mode de réalisation de la base, que ce soit par implantation ou épitaxie, par exemple.

Selon l'invention, on réalise un bloc d'oxyde sur une couche isolante formé au-dessus de la base intrinsèque (cette couche isolante pouvant être par exemple formée de deux sous-couches isolantes en deux diélectriques différents, par exemple du dioxyde de silicium et du nitrure de silicium). Le bloc d'oxyde comporte une partie inférieure plus étroite s'étendant dans un orifice gravé de la couche isolante, orifice gravé dont les dimensions correspondent à celles de la fenêtre-émetteur. Le bloc d'oxyde comporte également une partie supérieure plus large reposant sur la couche isolante, les bords latéraux de l'orifice gravé de la couche isolante étant auto-alignés avec les bords latéraux de la partie supérieure du bloc d'oxyde. On réalise alors l'implantation de la base extrinsèque de part et d'autre de la partie supérieure du bloc d'oxyde. On obtient donc l'auto-alignement sur la partie supérieure du bloc d'oxyde, et par conséquent l'auto-alignement sur les bords latéraux de l'orifice gravé, et donc de la fenêtre-émetteur.

Selon un mode de mise en oeuvre, la réalisation du bloc d'oxyde comporte :
- la formation d'une couche sacrificielle (par exemple en polysilicium), au-dessus de la couche isolante,
- la formation dans la couche sacrificielle, par photolithographie puis gravure, d'une cavité dont les dimensions correspondent aux dimensions de la partie supérieure du bloc d'oxyde,
- la formation par dépôt d'oxyde puis gravure anisotrope pleine plaque sans résine, d'espaceurs reposant sur la couche isolante et sur les parois verticales internes de ladite cavité, l'espacement entre les espaceurs définissant la largeur de la fenêtre-émetteur,
- une gravure partielle de la couche isolante entre les espaceurs de façon à former ledit orifice,
- le remplissage par de l'oxyde, d'une part de l'évidement situé entre les espaceurs, et d'autre part de l'orifice, et le retrait de la couche sacrificielle de façon à laisser subsister sur la couche isolante le bloc d'oxyde de part et d'autre duquel on réalise l'implantation de base extrinsèque.

La couche isolante comporte de préférence une première sous-couche formée d'un premier oxyde de silicium (par exemple SiO₂) surmontée d'une deuxième sous-couche formée d'un deuxième diélectrique (par exemple Si₃N₄). Les espaceurs et le bloc d'oxyde sont formés du premier oxyde de silicium (par exemple SiO₂). La gravure de la cavité de la couche sacrificielle et la gravure des espaceurs s'effectuent avec arrêt sur la deuxième sous-couche isolante (Si₃N₄). Ledit orifice dont les dimensions correspondent à celles de la fenêtre-émetteur, est alors gravé dans la deuxième sous-couche isolante (Si₃N₄).

La couche sacrificielle peut être du polysilicium, ou bien du silicium-germanium, ce qui facilite le retrait de la couche sacrificielle.

Le retrait de la couche sacrificielle s'effectue de préférence par une gravure isotrope plasma, utilisant un mélange gazeux d'acide bromhydrique (HBr) et d'oxygène, dans un rapport volumique de l'ordre de 10, avec une pression supérieure à 15 mTorr. On obtient ainsi une très bonne sélectivité vis-à-vis à la fois du matériau du bloc d'oxyde et du nitrure de silicium.

Selon un mode de mise en oeuvre de l'invention, la réalisation de l'émetteur comporte une gravure du bloc d'oxyde et de la partie de la couche isolante située dans la fenêtre-émetteur, la formation d'une couche de polysilicium sur les parties non gravées de la couche isolante et sur la partie de la base intrinsèque située dans la fenêtre-émetteur, et une gravure de la couche de polysilicium de façon à former ledit bloc-émetteur.

La base peut être une base à hétérojonction silicium-germanium et la formation de la région de base peut comporter une épitaxie d'un empilement de couches de silicium-germanium.

Par ailleurs, selon un mode de mise en oeuvre de l'invention, la réalisation de l'émetteur peut comporter une épitaxie sur la fenêtre-émetteur de la surface supérieure de l'empilement de base, de façon à obtenir au moins au-dessus de ladite fenêtre, une région d'émetteur formée de silicium monocristallin et directement en contact avec la couche supérieure dudit empilement.

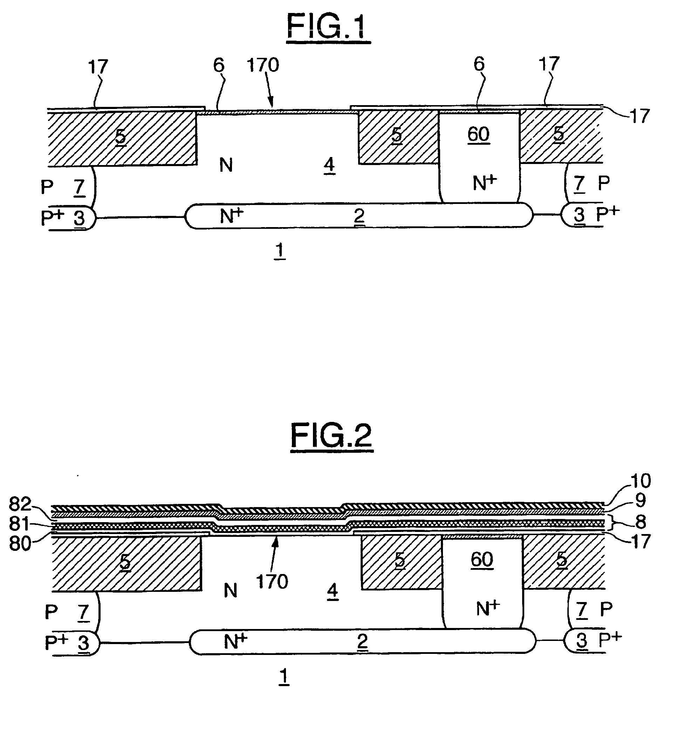

D'autres avantages et caractéristiques de l'invention apparaîtront à l'examen de la description détaillée d'un mode de mise en oeuvre, nullement limitatif, et des dessins annexés, sur lesquels : les figures 1 à 12 illustrent schématiquement un mode de mise en oeuvre du procédé selon l'invention.

Sur la figure 1, la référence 1 désigne un substrat de silicium, par exemple du type P, à la surface duquel on réalise de façon classique et connue en soi une couche enterrée 2 de collecteur extrinsèque, dopée N⁺, par une implantation d'arsenic.

On réalise de même, de façon classique, de part et d'autre du collecteur extrinsèque 2, deux couches enterrées 3, dopées P⁺, à partir d'une implantation de bore.

Sur le substrat 1 ainsi formé, on réalise une épitaxie épaisse, connue en soi, de façon à réaliser une couche 4 de silicium monocristalline de type N, ayant une épaisseur typiquement de l'ordre de 1 micron.

On réalise ensuite dans cette couche 4, de façon connue en soi, une région d'isolement latéral 5, soit par un procédé d'oxydation localisé (ou LOCOS), soit du type "tranchée peu profonde" ("Shallow Trench").

On a représenté, sur la figure 1, à des fins de simplification, une région d'isolement latéral 5 du type à tranchée peu profonde.

On réalise également, de façon classique, notamment par implantation de phosphore, un puits collecteur 60 dopé N⁺ contactant la couche enterrée 2.

On réalise ensuite des implantations de bore de façon à réaliser sous la région d'isolement latéral 5 des caissons 7 dopés P, permettant un isolement vis-à-vis des transistors adjacents au transistor bipolaire décrits ici.

On fait croître ensuite, de façon classique, sur la surface du collecteur intrinsèque monocristallin épitaxié 4, un oxyde thermique, typiquement du dioxyde de silicium. Cette croissance de dioxyde de silicium se produit également sur toute la plaquette, et notamment sur le puits collecteur 60. Cet oxyde forme également l'oxyde de grille pour les transistors complémentaires à effet de champ à grille isolée (transistors CMOS) réalisés conjointement aux transistors bipolaires sur la même plaquette (technologie BiCMOS : bipolaire CMOS).

On dépose ensuite sur le bloc semi-conducteur ainsi formé, une couche 17 de silicium polycristallin ayant une épaisseur de l'ordre de 500 Å.

On grave ensuite, par gravure plasma avec arrêt sur la couche d'oxyde 6, une fenêtre 170 dite "fenêtre de base".

Dans le cas où un isolement latéral du type tranchée peu profonde est utilisé, les deux parties de la couche 17 de silicium gravée débordent légèrement au-dessus du collecteur intrinsèque 4. Dans le cas où un isolement latéral du type "locos" est utilisé, la fenêtre 170 de gravure peut être plus large que le collecteur intrinsèque 4.

On procède ensuite (figure 2) à une désoxydation chimique de la couche d'oxyde 6 située au-dessus du collecteur. Il convient de noter ici que l'une des fonctions de la couche de silicium polycristallin 17 est une fonction de protection du reste de la plaquette, lors de cette désoxydation chimique et notamment des zones d'isolement latéral lorsque celles-ci sont réalisées par les tranchées peu profondes.

On procède ensuite, après un traitement de désorption de la fenêtre de base sous hydrogène à une température supérieure à 600°C, à une épitaxie d'un empilement 8 de trois couches 80, 81 et 82, au sein desquelles sera réalisée la future base du transistor. Plus précisément, on procède à une épitaxie d'une première couche 80 de silicium non dopée sur une épaisseur de quelques dizaines de nanomètres. La deuxième couche 81 formée de silicium-germanium est ensuite épitaxiée. Elle est en fait composée d'une première sous-couche de Si₁₋ₓGeₓ avec x constant compris entre 0,1 et 0,2, surmontée d'une deuxième sous-couche formée également d'un alliage de Si₁₋ₓGeₓ (avec x par exemple décroissant jusqu'à 0) et dopée P par du bore. L'épaisseur totale de la couche 81 est peu importante, typiquement de 20 à 100 nm.

La deuxième sous-couche de la couche 81 est ensuite surmontée d'une couche épitaxiée 82 de quelques dizaines de nanomètres d'épaisseur de silicium dopée P à partir de bore.

A l'issue de cette épitaxie, réalisée typiquement à 700°C dans un réacteur de dépôt CVD ultra propre, on obtient donc un empilement de couches monocristallines sur le collecteur intrinsèque dans la fenêtre de base, et polycristallines au-dessus des couches de silicium polycristallin 17. Cet empilement de couches doit permettre de former une base à hétérojonction silicium-germanium.

Il est à noter ici que l'épitaxie de réalisation de la base à hétérojonction est une épitaxie non sélective.

Cependant, l'invention s'applique à tout type de base, qu'elle soit silicium ou silicium-germanium, et quel que soit son mode de réalisation, que ce soit par épitaxie sélective ou non, ou par exemple par implantation directement dans le collecteur.

Il convient également de noter ici que la présence de la couche de silicium polycristallin 17 permet de présenter en début d'épitaxie une surface essentiellement formée de silicium, ce qui permet d'obtenir une vitesse de croissance sensiblement identique sur le collecteur intrinsèque et sur le silicium polycristallin, conduisant à l'obtention d'une meilleure homogénéité en l'épaisseur de la base.

On dépose ensuite sur la couche 81, une première sous-couche isolante de dioxyde de silicium 9 ayant une épaisseur de l'ordre de 200 Å (10Å = 1nm).

On dépose sur la première sous-couche de dioxyde de silicium 9, une deuxième sous-couche isolante 10 de nitrure de silicium (Si₃N₄) ayant une épaisseur de l'ordre de 300 Å.

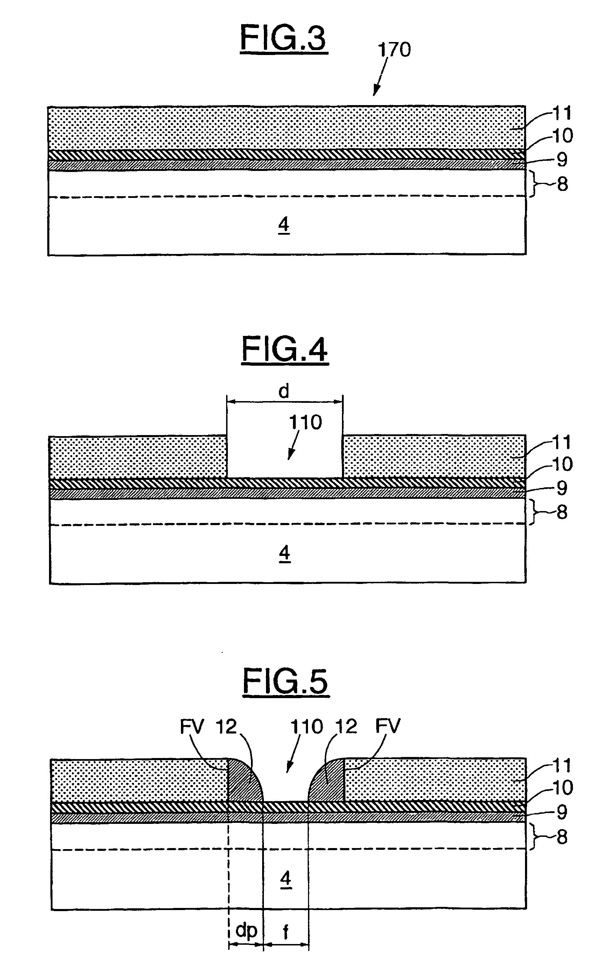

On va décrire maintenant en se référant plus particulièrement aux figures 3 à 8, la réalisation de la fenêtre-émetteur et de la base extrinsèque.

A des fins de simplification, et pour des raisons de clarté, on n'a représenté sur les figures 3 à 8 que la partie du transistor située au-dessus de la fenêtre de base 170 ménagée au-dessus du collecteur intrinsèque 4.

On dépose sur la sous-couche de nitrure 10, une couche dite "couche sacrificielle" 11, formée ici de polysilicium et ayant par exemple une épaisseur de l'ordre de 2000 Å.

On procède ensuite par une photolithographie classique, à une délimitation d'une cavité 110 dans la couche sacrificielle 11, en utilisant un masque de photolithographie. On effectue ensuite une gravure du polysilicium avec arrêt sur la sous-couche 10, de façon à former ladite cavité 110 (figure 4).

On effectue ensuite sur le bloc illustré sur la figure 4, un dépôt conforme d'oxyde, par exemple du dioxyde de silicium SiO₂, puis on forme, de façon classique et connue en soi, des zones latérales isolantes ou espaceurs 12, s'appuyant à la fois sur la sous-couche de nitrure 10 et sur les flancs latéraux internes de la cavité 110 de la couche sacrificielle 11. Cette formation d'espaceurs 12 comporte notamment une gravure anisotrope effectuée pleine plaque sans résine.

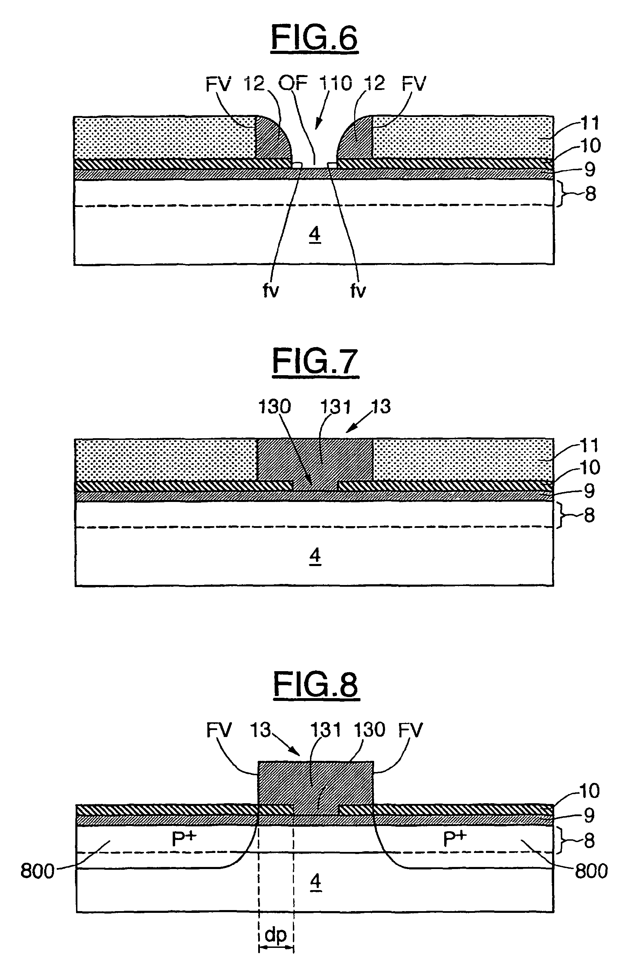

L'espacement f (figure 5) entre les espaceurs 12, définit la largeur de la fenêtre-émetteur.

Comme on le verra plus en détail ci-après, l'implantation de la base extrinsèque se fera de part et d'autre des flancs verticaux FV des espaceurs, c'est-à-dire à une distance dp des limites externes de la fenêtre-émetteur. Cette distance dp est prédéterminée et spécifiée de façon à garantir une absence de contact entre les zones implantées de base extrinsèque compte tenu de leur extension après diffusion, et la zone diffusée N⁺⁺ de dopants se situant sous la fenêtre-émetteur dans la région de base, cette zone N⁺⁺ résultant du dopage de l'émetteur comme on le verra plus en détail ci-après.

Bien entendu, la distance dp tient compte également des marges de tolérance dues aux variations du process.

En conséquence, l'homme du métier saura ajuster la valeur de la dimension d de la cavité 110 ainsi que l'épaisseur d'oxyde conforme permettant la réalisation des espaceurs 12, de façon à obtenir une valeur souhaitée pour la fenêtre f, ainsi que la valeur spécifiée pour la distance dp.

A titre indicatif, on pourra choisir une valeur de 0,6 micron pour la dimension d, ce qui est compatible avec l'obtention d'espaceurs dont la largeur au pied dp est de l'ordre de 0,15 micron, conduisant à une fenêtre-émetteur de largeur 0,3 à 0,4 micron.

On procède ensuite (figure 6) à une gravure classique de la portion de la sous-couche isolante de nitrure 10 située entre les espaceurs 12, de façon à graver un orifice OF. Cette gravure est sélective par rapport à l'oxyde (SiO₂) formant la première sous-couche isolante 9.

Il convient de noter ici qu'aucun niveau de photolithographie n'a été nécessaire pour délimiter et graver l'orifice OF, qui correspond à la fenêtre-émetteur. En conséquence, les flancs verticaux fv de l'orifice OF sont auto-alignés par rapport aux flancs verticaux FV des espaceurs.

L'étape suivante consiste à déposer sur l'ensemble illustré sur la figure 6, un oxyde épais de façon à remplir l'orifice gravé OF ainsi que l'évidement situé entre les espaceurs 12. On procède ensuite à une planarisation de cet oxyde, par des techniques classiques et connues en elles-mêmes, par exemple un polissage mécano-chimique, de façon à obtenir, comme illustré sur la figure 7, un bloc d'oxyde 13 ayant une partie inférieure 130 plus étroite et s'étendant dans la sous-couche isolante 10, ainsi qu'une partie supérieure plus large 131 débordant de la fenêtre-émetteur et reposant sur la région de base 8 par l'intermédiaire de l'empilement isolant 9,10.

On procède ensuite à une gravure de la couche sacrificielle 11 située de part et d'autre du bloc d'oxyde 13. Cette gravure est avantageusement une gravure isotrope présentant une sélectivité forte par rapport, d'une part au dioxyde de silicium SiO₂ constituant le bloc d'oxyde 13, et d'autre part au nitrure de silicium constituant la deuxième sous-couche 10. Cette sélectivité forte et cette isotropie forte permettent, comme illustré sur la figure 8, d'obtenir des flancs FV quasiment verticaux pour le bloc d'oxyde 13. Une telle gravure peut être effectuée à l'aide d'un plasma gazeux comportant un mélange d'acide bromhydrique et d'oxygène dans un rapport volumique d'environ 10 (dix fois plus d'acide bromhydrique que d'oxygène) avec une pression supérieure à 15 mTorr. On obtient alors une sélectivité d'environ 200 par rapport au dioxyde de silicium et d'environ 10 par rapport au nitrure de silicium.

On effectue ensuite une implantation P⁺ de part et d'autre du bloc d'oxyde 13, de façon à former les zones implantées 800 de base extrinsèque.

Puisqu'un seul masque de photolithographie a été nécessaire pour définir les flancs verticaux FV ainsi que la fenêtre-émetteur, l'implantation de base extrinsèque est par conséquent auto-alignée sur la fenêtre-émetteur.

De ce fait, il n'est pas nécessaire de prendre en compte une quelconque tolérance d'alignement de masques de photolithographie pour spécifier la distance prédéterminée dp séparant les limites de la fenêtre-émetteur des limites de la base extrinsèque implantée. En conséquence, la tolérance sur la distance dp peut être réduite d'autant, à savoir réduite de l'ordre de 0,18 micron, qui représente actuellement la tolérance minimale d'alignement de deux masques de photolithographie.

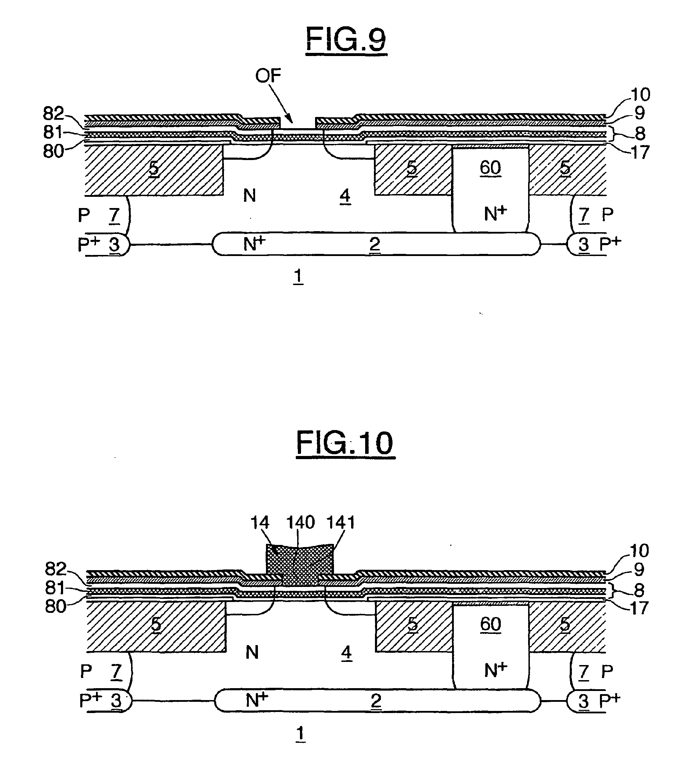

On procède ensuite à un retrait du bloc d'oxyde 13 et de la portion de sous-couche isolante 9 sous-jacente, de façon à obtenir la configuration illustrée sur la figure 9, sur laquelle on a de nouveau représenté la structure obtenue dans son ensemble, c'est-à-dire au-delà de la fenêtre de base. Ce retrait du bloc d'oxyde 13 peut s'effectuer de façon classique et connue en soi par une gravure chimique dans un bain d'acide fluorhydrique.

Pour permettre d'obtenir une surface de silicium monocristallin chimiquement propre, c'est-à-dire dont la concentration d'atomes d'oxygène est inférieure 10¹⁵ cm², on peut également effectuer dans la fenêtre-émetteur un traitement chimique de désoxydation en utilisant un bain d'acide à base fluorhydrique dilué à environ 1% pendant 1 minute. Une telle désoxydation chimique ne dégrade pas la surface de silicium monocristallin sous-jacente et par conséquent n'introduit pas de défaut cristallin.

Pour parfaire encore l'état de surface du silicium dans la fenêtre-émetteur, on effectue avantageusement un traitement de désorption sous hydrogène à haute température (supérieure à 550°C) de façon à évacuer des impuretés résiduelles adsorbées sur la surface du silicium lors de la désoxydation.

On procède ensuite dans un réacteur de dépôt CVD ultrapropre, par exemple celui commercialisé par la Société APPLIED MATERIALS sous la référence CENTURA HTF, à la réalisation de l'émetteur du transistor.

Plus précisément, on expose le bloc semi-conducteur avec la base découverte au niveau de la fenêtre-émetteur à un mélange gazeux de silane et d'arsine dans une atmosphère non-oxydante, typiquement sous vide ou sous hydrogène.

Les conditions du dépôt CVD sont par exemple un débit de 10 litres d'hydrogène par minute, un débit de 0,5 litre de silane par minute et un débit de 0,12 cm³ d'arsine par minute, à 630°C et sous une pression de 80 Torr (1 Torr = 133.3 Pa).

L'homme du métier aura remarqué que ces conditions correspondent en fait à un dépôt polysilicium. Cependant, en raison du caractère chimiquement propre de la surface monocristalline de la base découverte au niveau de la fenêtre-émetteur, le silicium déposé dans ce réacteur, épitaxie, c'est-à-dire qu'il croît monocristallin sur la base.

Après avoir obtenu une couche de silicium ayant une épaisseur de l'ordre de 2500 Å, on procède, de façon classique, en utilisant un nouveau masque de photolithographie ainsi qu'un bloc correspondant de résine, à une gravure de la couche de silicium de façon à obtenir un émetteur 14 comportant dans la fenêtre-émetteur une partie inférieure 140 surmontée d'une partie supérieure 141 plus large que la fenêtre-émetteur. Cet émetteur a été dopé in situ et il est monocristallin au moins au voisinage de l'interface avec la base dans la fenêtre-émetteur (figure 10).

Il a été observé en pratique qu'il était monocristallin au voisinage de l'interface, polycristallin au-dessus du nitrure, et possédait une orientation préférentielle dans la partie épitaxie supérieure au-dessus de la fenêtre-émetteur.

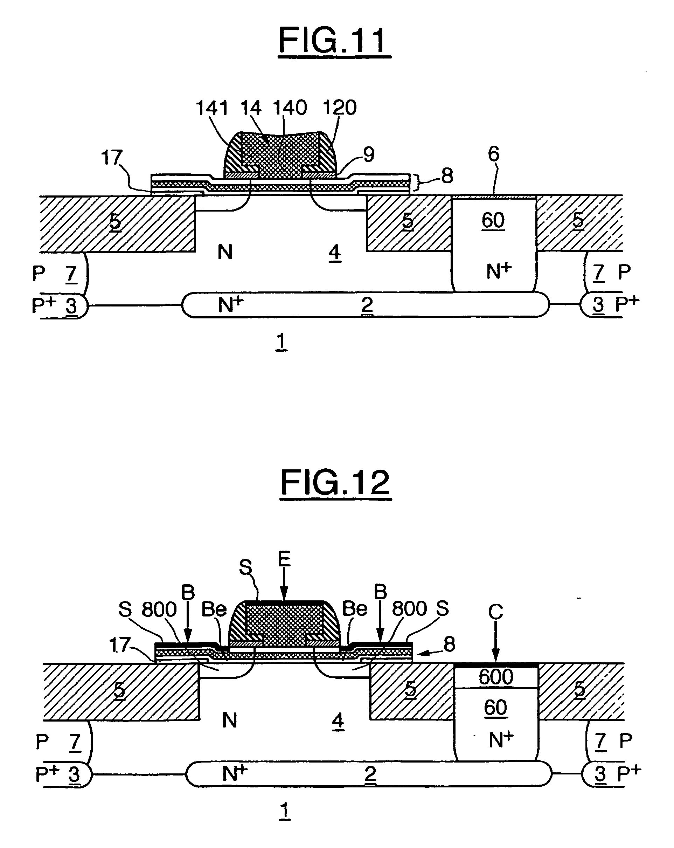

On procède ensuite à un dépôt d'une couche de nitrure de silicium que l'on grave de façon à obtenir des espaceurs 120, incluant la couche 10 de nitrure de silicium, s'appuyant sur les parois verticales de la région supérieure 141 de l'émetteur et sur la couche de dioxyde de silicium 9 (figure 11).

On définit ensuite, à l'aide d'un nouveau masque, la géométrie de la base du transistor et l'on procède, après avoir préalablement gravé la couche d'oxyde 9, à une gravure de l'empilement des couches 17 et 8, de façon à obtenir la configuration illustrée sur la figure 11.

L'étape finale consiste à réaliser les prises des connexions S de base, d'émetteur et de collecteur par une technique connue du type "siliciure auto-aligné" ("self aligned silicide") qui comporte le dépôt d'une couche de métal (par exemple du titane) pour former un siliciure TiSi₂ sur les zones de silicium de la base extrinsèque, de l'émetteur et du collecteur extrinsèques.

Le transistor, selon l'invention, tel qu'illustré sur la figure 12, est donc un transistor bipolaire vertical NPN à base à hétérojonction silicium-germanium, utilisable dans une technologie BiCMOS du type VLSI. Les zones extrinsèques sont auto-alignées sur la fenêtre-émetteur.

Par ailleurs, dans le mode de mise en oeuvre qui a été décrit, mais qui n'est pas limitatif, le transistor comporte un émetteur monocristallin directement en contact avec le silicium de la couche supérieure d'encapsulation 82. Cependant, en raison notamment des diffusions de dopants et de divers traitements thermiques classiques, la jonction émetteur-base se situe à l'intérieur de la couche 82. Le transistor présente, en raison de l'auto-alignement de la base extrinsèque sur la fenêtre-émetteur, une résistance d'accès à la base réduite. Le transistor présente également un bruit basse fréquence réduit, tout en conservant de bons paramètres statiques, notamment le gain en courant. Sa fréquence maximale d'oscillation est optimisée et il présente en outre une résistance d'émetteur réduite par rapport à des transistors à émetteur polycristallin.

## Revendications

1. Procédé de fabrication d'un transistor bipolaire comprenant une phase de réalisation d'une région de base (8) comportant une base extrinsèque (800) et une base intrinsèque, et une phase de réalisation d'une région d'émetteur (14) comprenant un bloc émetteur possédant une partie inférieure plus étroite (140) située dans une fenêtre-émetteur ménagée au dessus de la base intrinsèque, la réalisation de la base extrinsèque comportant une implantation de dopants (800) effectuée après une délimitation de la fenêtre-émetteur, de part et d'autre et à une distance prédéterminée (dp) des limites latérales de la fenêtre-émetteur, de façon auto-alignée sur cette fenêtre-émetteur, et avant la formation du bloc émetteur, c**aractérisé par** le fait qu'on réalise un bloc d'oxyde (13) sur une couche isolante (8, 10) formée au-dessus de la base intrinsèque, ce bloc d'oxyde comportant une partie inférieure plus étroite (130) s'étendant dans un orifice gravé (OF) de la couche isolante dont les dimensions correspondent à celles de la fenêtre-émetteur, et une partie supérieure plus large (131) reposant sur la couche isolante, les bords latéraux (fv) de l'orifice gravé de la couche isolante étant auto-alignés avec les bords latéraux (FV) de la partie supérieure du bloc d'oxyde (13), et on réalise l'implantation de la base extrinsèque de part et d'autre de la partie supérieure du bloc d'oxyde, et par le fait que la réalisation du bloc d'oxyde comporte
- la formation d'une couche sacrificielle (11) au-dessus de la couche isolante, la formation dans ladite couche sacrificielle, par photolithographie puis gravure, d'une cavité (110) dont les dimensions (d) correspondent aux dimensions de la partie supérieure du bloc d'oxyde,
- la formation par dépôt d'oxyde puis gravure anisotrope pleine plaque sans résine, d'espaceurs (12) reposant sur la couche isolante et sur les parois verticales internes de ladite cavité, l'espacement (f) entre les espaceurs définissant la largeur de la fenêtre-émetteur,
- une gravure partielle de la couche isolante (10) entre les espaceurs de façon à former ledit orifice (OF),
- le remplissage par de l'oxyde, d'une part de l'évidement situé entre les espaceurs (12), et d'autre part de l'orifice, et le retrait de la couche sacrificielle de façon à laisser subsister sur la couche isolante le bloc d'oxyde (13) de part et d'autre duquel on réalise l'implantation de base extrinsèque.

2. Procédé selon la revendication 1, **caractérisé par le fait que** la couche isolante comporte une première sous-couche (9) formée d'un premier diélectrique, par exemple un oxyde de silicium surmontée d'une deuxième sous-couche (10) formée d'un deuxième diélectrique, **par le fait que** les espaceurs (12) et le bloc d'oxyde (13) sont formés du premier oxyde de silicium, **par le fait que** la gravure de la cavité de la couche sacrificielle et la gravure des espaceurs (12) s'effectuent avec arrêt sur la deuxième sous-couche isolante (10), et **par le fait que** ledit orifice (OF) dont les dimensions correspondent à celles de la fenêtre-émetteur est gravé dans la deuxième sous-couche isolante (10).

3. Procédé selon la revendication 2, **caractérisé par le fait que** la couche sacrificielle (11) est formée de polysilicium.

4. Procédé selon la revendication 2, **caractérisé par le fait que** la couche sacrificielle(11) est formée de silicium-germanium.

5. Procédé selon la revendication 3 ou 4, **caractérisé par le fait que** le retrait de la couche sacrificielle (11) comporte une gravure isotrope plasma utilisant un mélange gazeux d'acide bromhydrique et d'oxygène dans un rapport volumique de l'ordre de 10, avec une pression supérieure à 15 mTorr 1 torr = 133.3 Pa.

6. Procédé selon l'une des revendications 1 à 5, **caractérisé par le fait que** la réalisation de l'émetteur comporte une gravure du bloc d'oxyde (13) et de la partie de la couche isolante (9) située dans la fenêtre-émetteur, la formation d'une couche de polysilicium sur les parties non gravées de la couche isolante et sur la partie de la base intrinsèque située dans la fenêtre-émetteur, et une gravure de la couche de polysilicium de façon à former ledit bloc émetteur (14).

7. Procédé selon l'une des revendications précédentes, **caractérisé par le fait que** la base (8) est une base à hétérojonction SiGe et **par le fait que** la formation de la région de base comporte une épitaxie d'un empilement de couches de silicium et de silicium-germanium (80-82).

8. Procédé selon la revendication 7, **caractérisé par le fait que** la réalisation de l'émetteur (14) comporte une épitaxie sur la fenêtre-émetteur de la surface supérieure de l'empilement de base, de façon à obtenir au moins au dessus de ladite fenêtre, une région d'emetteur formée de silicium monocristallin et directement en contact avec la couche supérieure dudit empilement.

## Patentansprüche

1. Verfahren zur Herstellung eines Bipolartransistors, das Folgendes aufweist: eine Phase zur Realisierung einer Basiszone (8) mit einer extrinsischen Basis (800) und einer intrinsischen Basis, und eine Phase zur Realisierung einer Emitterzone (14) mit einem Emitterblock, der einen schmaleren unteren Teil (140) aufweist, der sich in einem Emitter-Fenster befindet, das über der intrinsischen Basis ausgespart ist, wobei die Realisierung der extrinsischen Basis eine Implantation von Dotanten (800) aufweist, die nach einer Abgrenzung des Emitter-Fensters ausgeführt wird, beiderseits und mit einer vorbestimmten Distanz (dp) der Seitengrenzen des Emitter-Fensters, auf selbstjustierte Weise auf diesem Emitter-Fenster, und vor der Bildung des Emitterblocks, **dadurch gekennzeichnet, dass** man einen Oxidblock (13) auf einer Isolierschicht (8, 10) realisiert, die über der intrinsischen Basis gebildet ist, wobei dieser Oxidblock einen schmaleren unteren Teil (130) aufweist, der sich in einer geätzten Öffnung (OF) der Isolierschicht erstreckt, deren Abmessungen denjenigen des Emitter-Fensters entsprechen, und einen breiteren oberen Teil (131), der auf der Isolierschicht liegt, wobei die Seitenränder (fv) der geätzten Öffnung der Isolierschicht selbstjustiert mit den Seitenrändern (FV) des oberen Teils vom Oxidblock (13) sind, und dass man die Implantation der extrinsischen Basis beiderseits des oberen Teils des Oxidblocks realisiert und **dadurch**, dass die Realisierung des Oxidblocks Folgendes aufweist:
- die Bildung einer Opferschicht (11) über der Isolierschicht, die Bildung in der Opferschicht, durch Photolithographie und anschließendes Ätzen, eines Hohlraums (110) dessen Abmessungen (d) den Abmessungen des oberen Teils vom Oxidblock entsprechen,
- die Bildung durch Oxidablagerung und anschließendes anisotropes Vollplatte-Ätzen ohne Harz, von Distanzhaltern (12), die auf der Isolierschicht und auf den vertikalen Innenwänden des Hohlraums liegen, wobei der Abstand (f) zwischen den Distanzhaltern die Breite des Emitter-Fensters definiert,
- ein derartiges partielles Ätzen der Isolierschicht (10) zwischen den Distanzhaltern, dass die Öffnung (OF) gebildet wird,
- das Füllen durch Oxid, einerseits der Aussparung, die sich zwischen den Distanzhaltern (12) befindet, und andererseits der Öffnung, und das derartige Entfernen der Opferschicht, dass auf der Isolierschicht der Oxidblock (13) weiter besteht, beiderseits dem man die Implantation extrinsischer Basis realisiert.

2. Verfahren nach Anspruch 1, **dadurch gekennzeichnet, dass** die Isolierschicht eine erste Unterschicht (9) aufweist, die durch ein erstes Dielektrikum gebildet ist, zum Beispiel ein Siliziumoxid, die von einer zweiten Unterschicht (10) überlagert wird, die durch ein zweites Dielektrikum gebildet ist, **dadurch**, dass die Distanzhalter (12) und der Oxidblock (13) vom ersten Siliziumoxid gebildet sind, **dadurch**, dass das Ätzen des Hohlraums der Opferschicht und das Ätzen der Distanzhalter (12) mit Stopp auf der zweiten Unter-Isolierschicht (10) erfolgen, und **dadurch**, dass die Öffnung (OF), deren Abmessungen denjenigen des Emitter-Fensters entsprechen, in der zweiten Unter-Isolierschicht (10) geätzt ist.

3. Verfahren nach Anspruch 2, **dadurch gekennzeichnet, dass** die Opferschicht (11) aus Polysilizium gebildet ist.

4. Verfahren nach Anspruch 2, **dadurch gekennzeichnet, dass** die Opferschicht (11) aus Silizium-Germanium gebildet ist.

5. Verfahren nach Anspruch 3 oder 4, **dadurch gekennzeichnet, dass** das Entfernen der Opferschicht (11) ein isotropes Plasmaätzen aufweist, das ein Gasgemisch aus Bromwasserstoffsäure und Sauerstoff verwendet, mit einem Volumenverhältnis von 10, mit einem Druck über 15 mTorr (1 Torr = 133,3 Pa).

6. Verfahren nach einem der Ansprüche 1 bis 5, **dadurch gekennzeichnet, dass** die Realisierung des Emitters Folgendes aufweist: ein Ätzen des Oxidblocks (13) und des Teils der Isolierschicht (9), die sich im Emitter-Fenster befindet, die Bildung einer Polysilizium-Schicht auf den nicht geätzten Teilen der Isolierschicht und auf dem Teil der intrinsischen Basis, der sich im Emitter-Fenster befindet, und ein derartiges Ätzen der Polysilizium-Schicht, dass der Emitterblock (14) gebildet wird.

7. Verfahren nach einem der vorhergehenden Ansprüche, **dadurch gekennzeichnet, dass** die Basis (8) ist eine SiGe-Heterobasis ist und **dadurch**, dass die Bildung der Basiszone eine Epitaxie eines Stapels von Silizium- und Silizium-Germanium-(80-82) Schichten aufweist.

8. Verfahren nach Anspruch 7, **dadurch gekennzeichnet, dass** die Realisierung des Emitters (14) eine derartige Epitaxie auf dem Emitter-Fenster der oberen Fläche des Basisstapels aufweist, dass mindestens über dem Fenster eine Emitterzone erhalten wird, die aus monokristallinem Silizium gebildet ist und die in direktem Kontakt mit der oberen Schicht des Stapels ist.

## Claims

1. Process for fabricating a bipolar transistor comprising a phase of producing a base region (8) having an extrinsic base (800) and an intrinsic base and a phase of producing an emitter region (14) comprising an emitter block having a narrower lower part (140) located in an emitter window provided above the intrinsic base, the production of the extrinsic base comprising the implantation of dopants (800), carried out after definition of the emitter window, on either side of and at a predetermined distance (dp) from the lateral boundaries of the emitter window, so as to be self-aligned with respect to this emitter window and before the emitter block is formed **characterized in that** an oxide block (13) is produced on an insulating layer (8, 10) formed above the intrinsic base, this oxide block having a narrower lower part (130) extending into an orifice (OF) etched in the insulating layer, the dimensions of which etched orifice correspond to those of the emitter window, and a wider upper part (131) resting on the insulating layer, the lateral edges (fv) of the etched orifice in the insulating layer being self-aligned with the lateral edges (FV) of the upper part (13), and implantation of the extrinsic base is then carried out on either side of the upper part of the oxide block, and **in that** the production of the oxide block comprises:
- formation of a sacrificial layer (11) above the insulating layer, formation in the said sacrificial layer, by photolithography followed by etching, of a cavity (110) whose dimensions (d) correspond to the dimensions of the upper part of the oxide block;
- formation, by oxide deposition followed by whole-wafer resinless anisotropic etching, of spacers (12) resting on the insulating layer and on the internal vertical walls of the said cavity, the separation (f) between the spacers defining the width of the emitter window;
- partial etching of the insulating layer (10) between the spacers so as to form the said orifice (OF);
- filling, with oxide, on the one hand of the recess located between the spacers (12) and on the other hand of the orifice, and removal of the sacrificial layer so that the oxide block (13) is left on the insulating layer, the extrinsic base implantation taking place on either side of the oxide block.

2. Process according to Claim 1, **characterized in that** the insulating layer comprises a first sublayer (9) formed from a first dielectric, for example a silicon oxide, above which is a second sublayer (10) formed from a second dielectric, **in that** the spacers (12) and the oxide block (13) are formed from the first silicon oxide, **in that** the etching of the cavity in the sacrificial layer and the etching of the spacers (12) are carried out so as to stop on the second insulating sublayer (10) and **in that** the said orifice (OF), whose dimensions correspond to those of the emitter window, is etched in the second insulating sublayer (10).

3. Process according to Claim 2, **characterized in that** the sacrificial layer (11) is formed from polysilicon.

4. Process according to Claim 2, **characterized in that** the sacrificial layer (11) is formed from silicon-germanium.

5. Process according to Claim 3 or 4, **characterized in that** the removal of the sacrificial layer (11) comprises isotropic plasma etching using a gas mixture consisting of hydrobromic acid and oxygen in a volume ratio of the order of 10, and a pressure greater than 15 mTorr (1 torr = 133.3 Pa).

6. Process according to one of Claims 1 to 5, **characterized in that** production of the emitter comprises etching of the oxide block (13) and of that part of the insulating layer (9) which is located in the emitter window, formation of a polysilicon layer on the unetched parts of the insulating layer and on that part of the intrinsic base which is located in the emitter window, and etching of the polysilicon layer so as to form the said emitter block (14).

7. Process according to one of the preceding claims, **characterized in that** the base (8) is a base with a SiGe heterojunction and **in that** formation of the base region comprises epitaxial growth of a stack of silicon and silicon-germanium layers (80-82).

8. Process according to Claim 7, **characterized in that** production of the emitter (14) comprises epitaxial growth, on the emitter window, of the upper surface of the base stack so as to obtain, at least above the said window, an emitter region formed from monocrystalline silicon and directly in contact with the upper layer of the said stack.
